Europäisches Patentamt

European Patent Office

Office européen des brevets

(19)

(11) Veröffentlichungsnummer: **0 142 678**
**B1**

(12) **EUROPÄISCHE PATENTSCHRIFT**

(45) Veröffentlichungstag der Patentschrift: **28.11.90**

(21) Anmeldenummer: **84111531.4**

(22) Anmeldetag: **27.09.84**

(51) Int. Cl.⁵: **H 01 L 23/46,** H 01 L 25/11,
   H 01 L 23/64

(54) Halbleiterventil.

(30) Priorität: **06.10.83 SE 8305503**

(43) Veröffentlichungstag der Anmeldung:
   **29.05.85 Patentblatt 85/22**

(45) Bekanntmachung des Hinweises auf die
   Patenterteilung:
   **28.11.90 Patentblatt 90/48**

(84) Benannte Vertragsstaaten:
   **CH DE FR GB LI**

(56) Entgegenhaltungen:
   **DE-A-2 504 768**
   **DE-A-3 007 168**
   **FR-A-2 335 050**

(73) Patentinhaber: **ASEA AB**
   **S-721 83 Västeras (SE)**

(72) Erfinder: **Olsson, Karl-Erik**
   **Alvägen 14**
   **S-771 00 Ludvika (SE)**

(74) Vertreter: **Boecker, Joachim, Dr.-Ing.**
   **Rathenauplatz 2-8**
   **D-6000 Frankfurt a.M. 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 142 678 B1

**Beschreibung**

Die vorliegende Erfindung betrifft ein Halbleiterventil gemäß dem Oberbegriff des Anspruches 1. Solche Halbleiterventile sind beispielsweise aus der SE-A-334947 bekannt.

Halbleiterventile der vorgenannten Art werden beispielsweise in Stromrichtern zur Übertragung erlektrischer Energie mit Hilfe hochgespannten Gleichstroms oder als Teile von Schaltanlagen zur statischen Blindleistungskompensation verwendet.

Bei Ventilen dieser Art ist parallel zu den in Reihe geschalteten Halbleiterventilen eine Spannungsteilerkette derart angeordnet, daß zu jedem Halbleiterelement ein Spannungsteilerabschnitt parallel geschaltet ist. Jeder Spannungsteilerabschnitt besteht normalerweise aus einem oder mehreren Widerständen. Ventile mit solchen Spannungsteilern sind bereits beispielsweise aus den US-PSen 3794908 und 4360864 bekannt. Die genannten Spannungsteilerwiderstände haben eine große Verlustleistung, die üblicherweise in der Größenordnung von mehren hundert Watt liegt. Wenn die Widerstände luftgekühlt ausgeführt werden, so hat dies mehrere schwerwiegende Nachteile. Die Widerstände müssen mit Kühlflanschen oder dergleichen versehen werden und verhältnismäßig große Abmessungen haben, damit eine ausreichend große Wärmeabgabe an die umgebende Luft ohne einen allzu hohen Temperaturanstieg erreicht wird. Ferner muß man dafür sorgen, daß eine ausreichende Kühlluftströmung an den Widerständen vorbeigeführt wird, um die Verlustwärme abzutransportieren. Aus diesen Gründen ist ein Ventil dieser Art, wenn es mit luftgekühlten Widerständen ausgeführt wird, verhältnismäßig sperrig. Ein weiterer Nachteil besteht darin, daß die hohe Leistungsabgabe des Widerstandes eine hohe Lufttemperatur in dem Ventil und seiner Umgebung zur Folge hat, was eine erhöhte Betriebstemperatur für die im Ventil und im umgebenden Raum angeordneten Bauteile und Ausrüstungen zur Folge hat, wenn keine weiteren besonderen Kühlmaßnahmen getroffen werden.

Aus der US-PS 2274381 ist es bereits bekannt, Hochleistungswiderstände flüssigkeitsgekühlt auszuführen. Die Ausführung jedes der vielen in einem Halbleiterventil vorhandenen Spannungsteilerwiderstände in flüssigkeitsgekühlter Bauart würde ein kompliziertes Ventil mit vielen Schaltungen und Rohrverbindungen für die Kühlflüssigkeit bedeuten. Das Ventil würde weiterhin verhältnismäßig sperrig sein, und eine gewisse Wärmeabgabe von den Widerstände und den Kühlflüssigkeitsleitungen würde weiterhin zu einer erhöhten Temperatur der Luft in dem Ventil und des umgebenden Raumes führen.

Durch die US-PS 4 178 630 ist es bereis bekannt, die Spannungsteilerwiderstände auf einer Kühlschiene zur Flüssigkeitskühlung der Halbleiterelemente des Ventils zu montieren. Ein gewisser Teil der Verlustwärme der Widerstände wird dadurch von der die Schiene durchfließenden Kühlflüssigkeit wegtransportiert, jedoch ist die Wärmeabgabe an die umgebende Luft weiterhin verhältnismäßig hoch.

Der Erfindung liegt die Aufgabe zugrunde, ein Halbleiterventil der eingangs genannten Art zu entwickeln, bei welchem die Wärmeabgabe von den Spannungsteilerwiderstände an die umgebende Luft sehr gering ist.

Zur Lösung dieser Aufgabe wird ein Halbleiterventil gemäß dem Oberbegriff des Anspruches 1 vorgeschlagen, welches erfindungsgemäß die im kennzeichnenden Teil des Anspruches 1 genannten Merkmale hat.

Vorteilhafte Ausgestaltungen der Erfindung sind in den weiteren Ansprüchen genannt.

Anhand der in den Figuren gezeigten Ausführungsbeispiele soll die Erfindung näher erläutert werden. Es zeigen

Figur 1a und 1b ein Halbleiterventil gemäß der Erfindung,

Figur 2a, 2b und 2c den Aufbau eines Kühlkörpers des Halbleiterventils gemäß Figur 1 im Detail,

Figur 3a bis 3d ein zweites Ausführungsbeispiel der Kühlkörper des Ventils gemäß Figur 1,

Figur 4 eine Ausführungsform gemäß der Erfindung, bei der die Widerstände in separaten Platten untergebracht sind,

Figur 5 eine Ausführungsform gemäß der Erfindung, bei der die Widerstände in besonderen Löchern in den Kühlkörpern untergebracht sind.

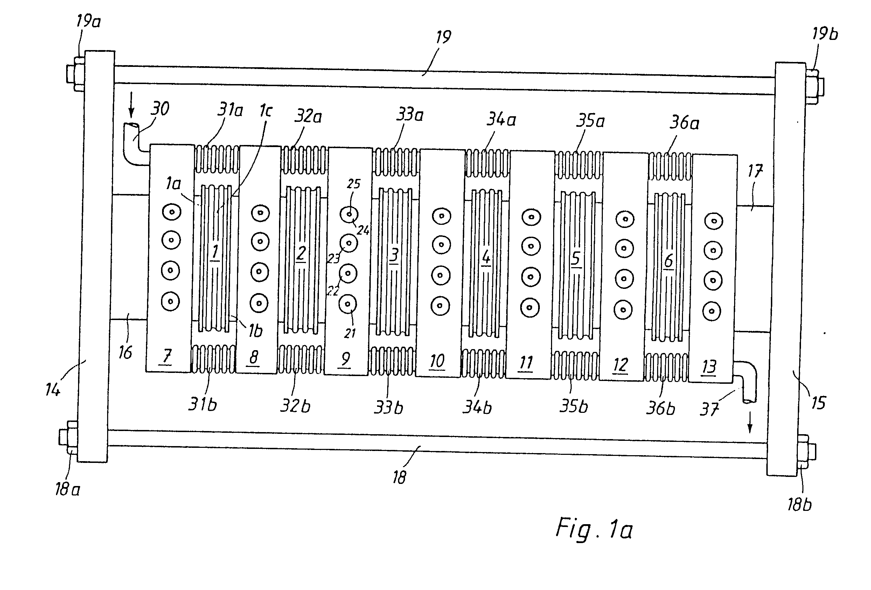

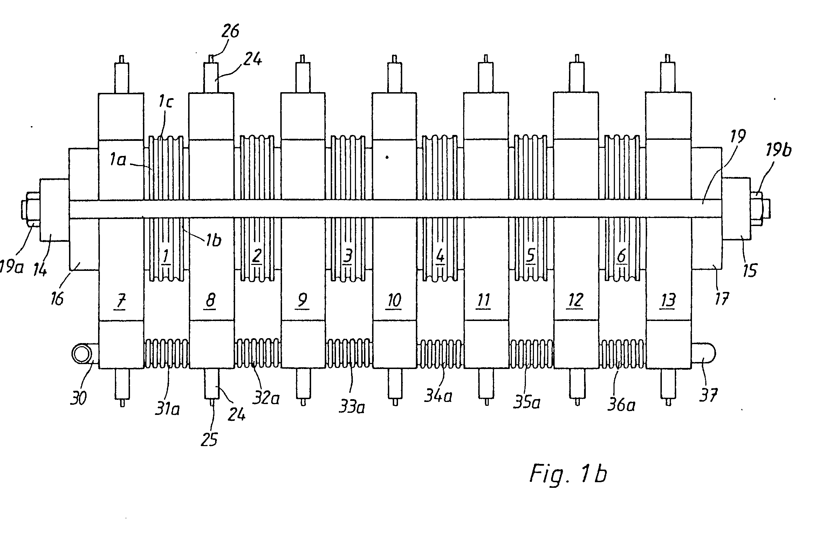

Die Figuren 1a und 1b zeigen ein Ausführungsbeispiel für ein Halbleiterventil gemäß der Erfindung, gesehen aus zwei zueinander senkrechten Richtungen, die beide senkrecht zur Längsachse des Ventils verlaufen. Das Ventil enthält sechs Halbleiterelemente 1-6, bei denen es sich um Thyristoren oder Dioden handeln kann. Die Kapsel jedes Halbleiterelements besteht aus zwei kreisförmigen metallischen Kontaktblechen 1a und 1b sowie einem ringförmigen Isolator 1c. Die Halbleiterelemente sind für Druckkontakt und für. Doppelkühlung ausgeführt, d.h. sie sind dazu vorgesehen, zwischen zwei auf je einer Seite des Halbleiterelementes angeordneten Kühlkörpern zusammengepreßt zu werden. Zwischen den Halbleiterelementen sowie außerhalb der beiden äußersten Halbleiterelemente sind Kühlkörper 7-13 angeordnet. Der aus den Kühlkörpern und den Halbleiterelementen gebildete Stapel wird mit Hilfe der Joche 14 und 15, der Zwischenkörper 16 und 17 und der Zugbolzen 18 und 19 mit den Muttern 18a, 18b, 19a, 19b mit einer verhältnismäßig großen Kraft, beispielsweise einigen Tausend N, zusammengepreßt. Durch das Zusammenpressen wird einerseits eine mechanische Stabilität des Stapels und andererseits der erforderliche gute elektrische und thermische Kontakt zwischen den Halbleiterelementen und den Kühlkörpern erreicht. Da zwischen den beiden Enden des Ventils eine hohe elektrische Spannung herrscht, muß die Anpreßanordnung 14-19 so aufgebaut sein, daß sie keinen elektrischen Kurzschluß zwischen den Enden des Ventils verursacht. Dies kann beispielsweise dadurch erreicht werden, daß elektrisch isolierende Platten zwischen den Körpern 16, 17 sowie den Kühlkörpern 7, 8 eingefügt werden, oder dadurch, daß die Zugbolzen 18, 19 und die Muttern 18a—19b gegenüber den Jochen 14, 15 elektrisch isoliert werden.

Die erforderlichen Leitungen für den elektrischen Anschluß des Ventils können beispielsweise mit den Kühlkörpern 7 und 13 verbunden werden. Ein Rohr 30 ist an den Kühlkörper 7 für die Zufuhr einer Kühlflüssigkeit, beispielsweise Wasser, angeschlossen. Das Rohr 30 sowie die elektrisch isolierenden Verbindungsrohre 31a-36a sind miteinander fluchtend angeordnet und mit Hilfe von Löchern in den Kühlkörpern 7-13 miteinander verbunden. Ein Abflußrohr 37 für den Abfluß von Kühlflüssigkeit ist mit dem Kühlkörper 13 verbunden. Mit diesem Rohr fluchtend sind die elektrisch isolierenden Verbindungsrohre 31b-36b angeordnet und durch Löcher in den Kühlkörpern 7-13 miteinander verbunden. Die Rohre 31a-36a und die mit diesen Rohren fluchtenden Löcher in den Kühlkörpern bilden zusammen eine Zuflußleitung für die Kühlflüssigkeit. Die Rohre 31b-36b und 37 sowie die mit diesen Rohren fluchtenden Löcher in den Kühlkörpern bilden in gleicher Weise eine Abflußleitung für die Kühlflüssigkeit. Von der Zuflußleitung strömt Kühlflüssigkeit parallel durch Kanäle in den sechs Kühlkörpern zu der Abflußleitung, von wo die Kühlflüssigkeit durch das Rohr 37 abtransportiert wird.

Gemäß der Erfindung sind zumindest gewisse der Spannungsteilerwiderstände, vorzugsweise diejenigen mit der größten Leistungsentwicklung, als metallgekapselte Widerstände ausgeführt, d.h. als längliche, zylinderförmige Rohre, in welchen je ein Widerstandselement zentral angeordnet und von dem Metallmantel mit Hilfe einer geeigneten Isoliermasse isoliert ist. Wie Figur 1 zeigt, sind vier Widerstände dieser Art in jedem Kühlkörper 7-13 angeordnet. Die beispielsweise in dem Kühlkörper 9 angeordneten Widerstände sind mit 21-24 bezeichnet. Die Widerstände sind so lang, daß sie auf jeder Seite des Kühlkörpers etwas herausragen, und dort sind ihre elektrischen Anschlüsse (25 und 26 für den Widerstand 24) leicht zugänglich. In den Kühlkörpern sind, wie nachstehend noch näher beschrieben wird, Kanäle auf solche Weise angebracht, daß die Widerstände von der durch die Kühlkörper fließenden Kühlflüssigkeit umspült werden.

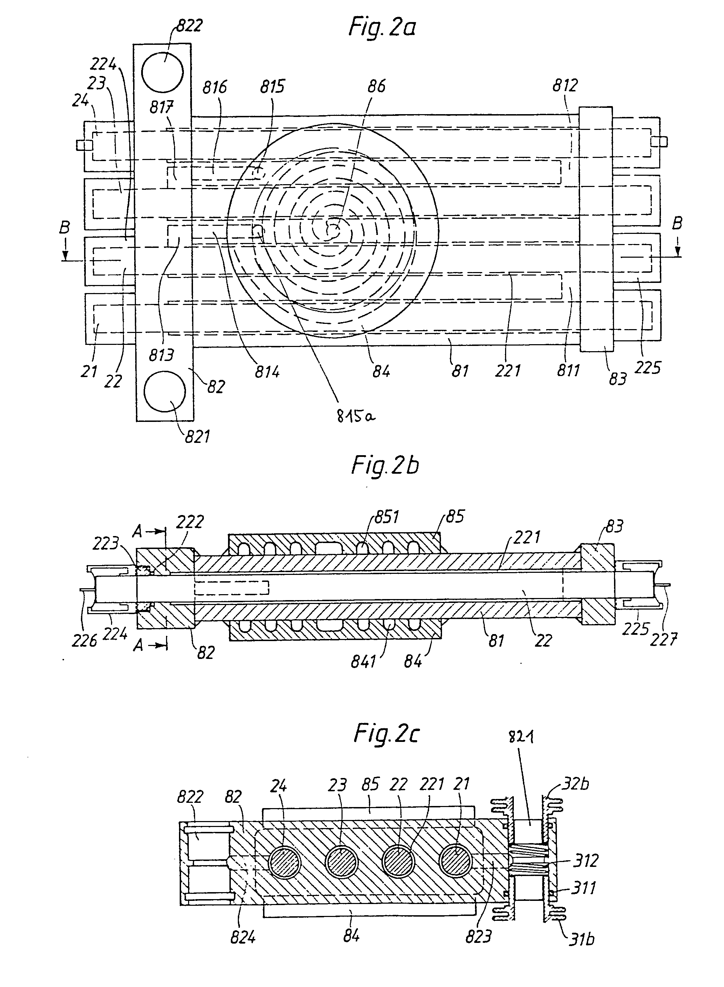

Figur 2 zeigt die Ausgestaltung eines der Kühlkörper im Detail, und zwar den Kühlkörper 8 in Figur 1. Die übrigen Kühlkörper sind mit dem in Figur 2 gezeigten identisch. Figur 2a zeigt den Kühlkörper in Längsrichtung des Ventilstapels gesehen, Figur 2b zeigt den Schnitt B—B in Figur 2a, und Figur 2c zeigt den Schnitt A—A Figur 2b. Der Kühlkörper besteht zum Beispiel aus einem Metall mit zweckmäßigen mechanischen, elektrischen und thermischen Eigenschaften, wie z.B. Kupfer, Leichtmetall oder einer Leichtmetalllegierung. Der Kühlkörper hat ein Hauptteil 81 und zwei Endstücke 82 und 83. Das Hauptteil 81 des Kühlkörpers ist im Prinzip ein massiver parallelepipedischer Körper, der mit vier parallelen, längsverlaufenden Löchern für die Widerstände 21-24 versehen ist. Das für den Widerstand 22 vorgesehene Loch ist mit 221 bezeichnet. Der Durchmesser der Löcher ist etwas größer als der Außendurchmesser der Widerstände, so daß sich zwischen den Widerständen und den Wänden der Löcher Kanäle bilden, durch welche die Kühlflüssigkeit in Längsrichtung der Widerstände fließen kann. An seinem in der Figur rechten Ende ist das Hauptteil 81 mit Aussparungen 811 und 812 versehen, die es ermöglichen, daß Kühlflüssigkeit zwischen den Löchern für die Widerstände 21 und 22 bzw. 23 und 24 fließt. Auf jeder Seite des Hauptteils 81 des Kühlkörpers ist je eine Kühlplatte 84 bzw. 85 angebracht. Diese sind mit spiralförmigen Kühlflüssigkeitskanälen 841 bzw. 851 versehen. Die beiden in der Mitte der Kühlplatten liegenden Enden des Kühlkanäle 841 und 851 sind durch ein quer durch den Kühlkörper 81 gehendes Loch 86 miteinander verbunden. Das periphere Ende des Kanals 841 ist an den Kühlflüssigkeitsfluß durch ein in dem Körper 81 angeordnetes Loch 815 und einen Kanal 816 angeschlossen, der zu dem in Figur 2a gezeigten linken Ende des Körpers 81 läuft. Auf entsprechende Weise ist das periphere Ende des Kanals 851 an den Kühlflüssigkeitsfluß durch ein Loch 815a und einen Kanal 814 angeschlossen, der zu dem in Figur 2a gezeigten linken Ende des Körpers 81 läuft. Das Endstück 82 ist mit dem Körper 81 fest verbunden und mit Bohrungen für die Widerstände 21-24 versehen. An ihrem am dichtesten am Körper 81 liegenden Teil haben die Bohrungen einen größeren Durchmesser als die Widerstände, um einen Kühlflüssigkeitsfluß zu ermöglichen. An ihren dem Körper 81 abgewandten Teilen haben die Bohrungen zweckmäßigerweise einen kleineren Durchmesser und sind mit Dichtungen zum Dichten gegen Kühlflüssigkeit versehen. Diese Dichtungen können beispielsweise, wie in Figur 2b gezeigt, aus einem O-Ring 222 sowie einer Mutter 223 bestehen. Die elektrischen Anschlüsse des Widerstandes 22 sind mit 226 und 227 bezeichnet. Um die elektrische Kriechstrecke zwischen den Anschlüssen und dem Kühlkörper zu vergrößern, werden zweckmäßigerweise zylindrische Schirme 224 und 225 an den Enden jedes Widerstandes angebracht.

Für die Zufuhr von Kühlflüssigkeit zum Kühlkörper ist das Endstück 82 mit einer Bohrung 822 versehen, über welche die isolierenden Rohre 31a und 32a (Figur 1) mit dem Einlaufrohr 30 für Kühlflüssigkeit verbunden sind. Von der Bohrung 822 geht ein Kanal 824 zu dem Kühlflüssigkeitskanal, der den Widerstand 24 umgibt. An seinem entgegengesetzten Ende ist das Endstück 82 mit einer zweiten Bohrung 821 für den Abfluß von Kühlflüssigkeit versehen, und diese Bohrung ist durch die isolierenden Rohre 31b und 32b mit den benachbarten Kühlkörpern und mit der Abflußleitung 37 verbunden. Figur 2c zeigt ein Beispiel dafür, wie die elektrisch isolierenden Rohre 31b und 32b dichtend an das Endstück 82 mit Hilfe von O-Ringen 311 und Schraubenfedern 312 angeschlossen sein können. Die Bohrung 821 ist durch einen Kanal 823 mit dem Kühlflüssigkeitskanal verbunden, der den Widerstand 21 umgibt.

Das Endstück 83 ist an dem in den Figuren 2a und 2b rechten Ende des Körpers 81 befestigt. In diesem Endstück sind keine Kühlflüssigkeitskanäle vorhanden; es enthält nur vier Löcher für die Widerstände 21-24. Das Endstück ist mit einer Dichtungsvorrichtung für die Kühlflüssigkeit versehen, die beispielsweise von gleicher Art ist, wie die in Figur 2b an dem Endstück 82 gezeigte.

Die Kühlflüssigkeit die dem Kühlkörper durch das Loch 822 zugeführt wird, folgt dem folgenden Kreislauf: Durch den Kanal 824 strömt die Kühlflüssigkeit zu dem linken Ende des Kanals, der den Widerstand 24 umgibt und folgt danach diesem Widerstand in axialer Richtung bis zu dessen rechtem Ende. Durch die Aussparung 812 fließt die Kühlflüssigkeit zu dem Kanal hinüber, der den Widerstand 23 umgibt, und folgt diesem Widerstand bis zu dessen in der Figur linke Ende. Durch die Aussparung 817, den Kanal 816 und das Loch 815 strömt die Kühlflüssigkeit dann zu dem peripheren Ende des spiralförmigen Kanals 841 in der Kühlplatte 84. Nachdem sie diesen letztgenannten Kanal durchflossen hat, strömt die Kühlflüssigkeit von dem zentralen Endpunkt dieses Kanals durch das Loch 86 zu dem zentralen Ende des Kanals 851 in der gegenüberliegenden Kühlplatte 85. Nachdem sie diesen letztgenannten Kanal durchströmt hat, strömt die Kühlflüssigkeit durch das Loch 815a, den Kanal 814 und die Aussparung 813 zu dem linken Endpunkt des Kanals 221, der den Widerstand 22 umgibt, und durch diesen Kanal 221 in Längsrichtung des Widerstandes. An dem in der Figur rechten Ende dieses Kanals fließt die Kühlflüssigkeit durch die Aussparung 811 zu dem Kanal, der den Widerstand 21 umgibt, folgt diesem Widerstand zu dessen linkem Ende und fließt dann durch den Kanal 823 zu dem Loch 821, das, wie vorstehend beschrieben, mit der Abflußleitung 37 verbunden ist. Eventuelle weitere Spannungsteilerkomponenten sowie elektronische Komponenten zur Speisung, Steuerung und zum Schutz der Thyristoren können zweckmäßigerweise auf dem Kühlkörper, am besten zwischen den Kühlplatten 84 und 85 und dem Endstück 83 plaziert werden, wodurch man auch eine Kuhlung dieser Komponenten erhält.

Das vorstehend beschriebene Halbleiterventil zeigt eine Kombination von Eigenschaften, die es im Vergleich zu bekannten Halbleiterventil außerordentlich vorteilhaft macht. Aufgrund der kurzen Wärmetransportwege zwischen der in den Kühlplatten 84 und 85 fließenden Kühlflüssigkeit und den Thyristoren erhält man eine außerordentlich effektive Kühlung der Thyristoren. Außerdem wird praktisch die gesamte in den Widerstände umgesetzte Verlustleistung direkt an die Kühlflüssigkeit abgegeben, und die Warmeabgabe an die umgebende Atmosphäre ist praktisch Null. Die wesentlich kleinere Wärmeabgabe an die Umgebungsluft ermöglicht eine kompaktere Bauweise als es bisher möglich gewesen ist und bewirkt außerdem eine niedrige Temperatur und eine große Zuverlässigkeit der übrigen in dem Ventil vorhandenen eletronischen Komponenten. Diese Vorteile erzielt man mit Hilfe eines einzigen Kühlkörpers, der kaum mehr Platz erfordert als ein nur zur Kühlung des Thyristors vorgesehener Kühler und der erheblich weniger Platz erfordert, als es bei Anordnung. eines separaten Flüssigkeitskühlers für die Spannungsteilerwiderstände der Fall wäre. Aus denselben Gründen ist das Gewicht eines Halbleiterventils der oben beschriebenen Ausführung kleiner als das eines bekannten Ventils mit entsprechenden Eigenschaften. Das Halbleiterventil gemäß der Erfindung enthält außerdem eine sehr kleine Anzahl von Rohrkupplungen, Schlauchkupplungen usw., wodurch die Montage sehr einfach und die Gefahr eines Lecks klein wird. Der in Figur 2 gezeigte Kühlkörper hat, wie aus den Figuren 2b und 2c hervorgeht, reichlich massives Material zwischen den Kühlkanälen, so daß die auf den Ventilstapel wirkenden hohen Druckkräfte keine Verformungen hervorrufen, was für einen guten elektrischen und thermischen Kontakt zwischen den Thyristoren und den Kühlkörpern wichtig ist. Wie aus Figur 2 hervorgeht, ist ferner die Montage und Demontage der in dem Kühler angebrachten Widerstände 21-24 außerordentlich einfach, was sowohl bei der Herstellung des Ventils wie bei einer eventuellen späteren Kontrolle der Widerstände oder bei einem Austausch der Widerstände wichtig ist.

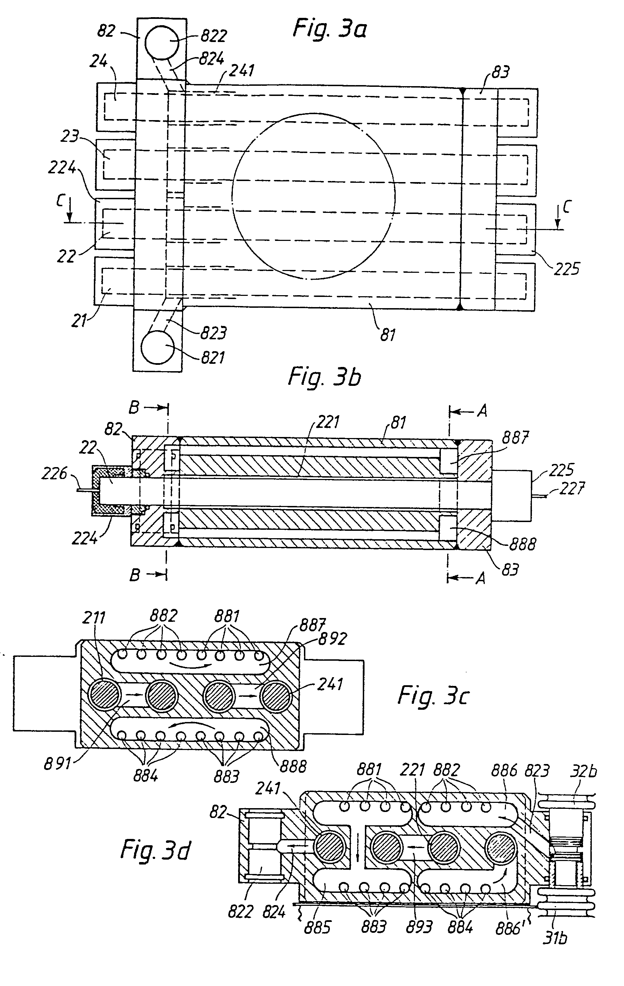

Figur 3 zeigt eine alternative Ausführungsform eines Kühlkörpers gemäß der Erfindung. Figur 3a zeigt den Kühlkörper gesehen in Längsrichtung des Ventilstapels. Figur 3b zeigt einen Schnitt längs der Linie C—C in Figur 3a, Figur 3c und Figur 3d zeigen einen Schnitt längs der Linie A-A bzw. B-B in Figur 3b. Der Unterschied zwischen den in Figur 2 und 3 gezeigten Kühlkörpern besteht darin, daß der Kühlkörper nach Figur 3 keine Kühlplatten 84 und 85, sondern stattdessen nahe der Oberfläche des Kühlkörpers liegende Kühlkanäle 881, 882, 883, 884 für eine effektive Kühlung der Halbleiterelemente hat. Dies hat zur Folge, daß die Kühlflüssigkeitswege im Kühlkörper anders verlaufen, als bei der Ausführungsform gemäß Figur 2. In dem in Figur 3a und Figur 3b rechten Ende des Hauptteils 81 des Kühlkörpers sind Aussparungen 887 und 888 angebracht, welche die in Figur 3b und Figur 3c gezeigte Form haben. Die Aussparung 887 verbindet die Kanäle 881 mit den Kanälen 882, und die Aussparung 888 verbindet die Kanäle 883 mit den Kanälen 884. Auf gleiche Weise wie in Figur 2, sind ferner Aussparungen 891 und 892 vorhanden, welche die die Widerstände 21 und 22 beziehungsweise 23 und 24 umgebenden Kühlkanäle verbinden.

In dem Endstück 82 sind Aussparungen 885, 886, 886', 893 sowie Kanäle 824 und 823 (Figur 3d) angeordnet. Die Aussparung 885 bildet eine Verbindung zwischen den Kanälen 881 und 883, die Aussparung 886 bildet einen Sammelraum für die Kanäle 882, die Aussparung 886' bildet einen Sammelraum für die Kanäle 884, die Aussparung 893 verbindet die um die Widerstände 22 und 23 liegenden Kühlflüssigkeitskanäle, der Kanal 823 dient als Einlaufrohr für den Sammelraum 886, und der Kanal 824 dient als Abflußleitung von dem um dem Widerstand 24 angebrachten Kühlkanal 241. Die Kühlflüssigkeit fließt von der Zuflußleitung 821 durch den Kanal 823, die Aussparung 886 und die Kanäle 882 zur Aussparung 887, wo sie zu den Kanälen 881 hinüberfließt und durch diese zu der Aussparung 885. Durch diese fließt die Kühlflüssigkeit zu den Kanälen 883, durch diese zu der Aussparung 888 und durch die Kanäle 884 zu der Aussparung 886'. Von der Aussparung 886 fließt die Kühlflüssigkeit durch den Widerstand 21 umgebenden Kühlkanal 211, die Aussparung 891, den den Widerstand 22 umgebenden Kühlkanal 221, die Aussparung 893, den den Widerstand 23 umgebenden Kühlkanal, die Aussparung 892, den den Widerstand 24 umgebenden Kühlkanal 241 sowie den Kanal 824 zu der Abflußleitung 822.

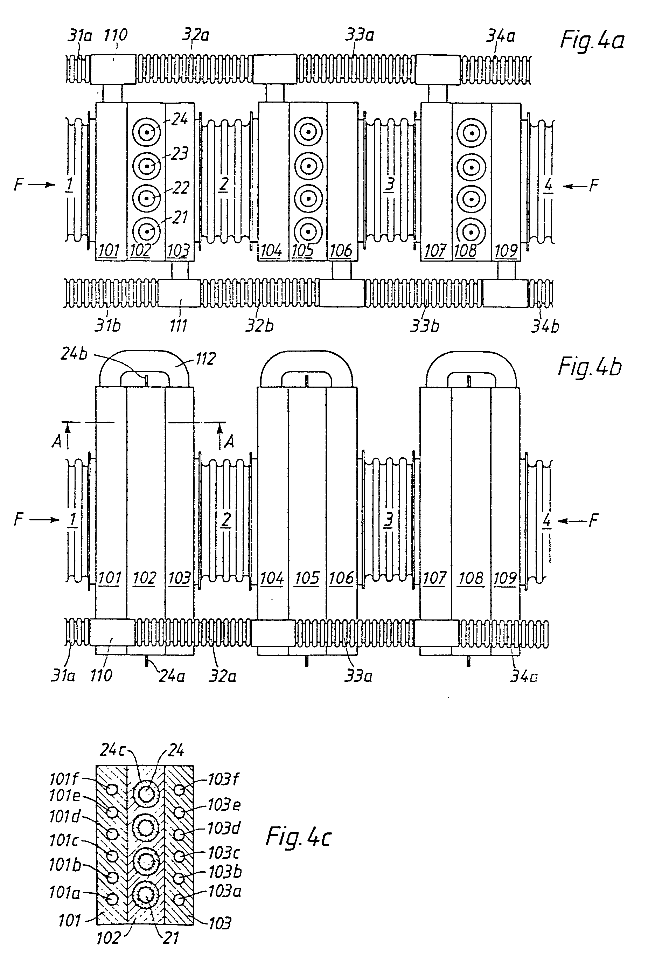

Figur 4 zeigt eine weitere Ausführungsform eines Halbleiterventils gemäß der Erfindung. Figur 4a und Figur 4b zeigen einen Teil des Ventilstapels, gesehen in zwei zueinander senrechten Richtungen und Figur 4c zeigt einen Schnitt längs der Linie A-A in Figur 4b. Zwischen zwei Halbleiterelement (z.B. 1 und 2) ist ein Kühlkörper angebracht, der aus einer zwischen zwei Kühlplatten 101, 103 angebrachten Widerstandsplatte 102 besteht. Die Widerstandsplatten bestehen genau wie die Kühlplatten aus parallelepipedischen Leichtmetallkörpern. Die Kühlplatten 101 und 103 sind mit mehreren längslaufenden, parallelen Kühlflüssigkeitskanälen 101a-101f bzw. 103a-103f versehen. Die Kühlplatte 101 ist mit einem Einlaufrohr 110 für Kühlflüssigkeit versehen. Die Einlaufrohre 110 für die Kühlplatten 101, 104, 107 usw. sind durch Rohre 31a-34a aus elektrisch isolierendem Material miteinander verbunden und bilden zusammen mit diesen die Zuflußleitung. Die Kühlplatte 103 ist mit einem Abflußrohr 111 für die Kühlflüssigkeit versehen, durch welches die isolierenden Rohre 31b-34b mit den Abflußrohren an den Kühlplatten 106, 109 usw. verbunden sind. Jede Kühlplatte hat an beiden Enden einen Sammelraum für Kühlflüssigkeit, welcher die Kühlflüssigkeit auf die parallelen Kanäle verteilt bzw. von den Kanälen sammelt. Ein Rohr 112, das zweckmäßigerweise ein mit den Kühlplatten 101 und 103 fest verbundenes Metallrohr sein kann, verbindet die Kühlkanäle in den beiden Kühlplatten.

Kühlflüssigkeit strömt also aus der Zuflußleitung durch das Einlaufrohr 110 zu der Kühlplatte 101, wo sie die Kanäle 101a-101f durchfließt. Durch das Rohr 112 fließt die Kühlflüssigkeit zu der Kühlplatte 103, wo sie die Kühlkanäle 103a-103f durchfließt und die Kühlplatte zum Schluß durch das Abflußrohr 111 verläßt.

Die Widerstandsplatte 102 ist eine separate Platte, die während des Betriebs durch die auf den Ventilstapel wirkende axiale Kraft F zwischen den Kühlplatten 101 und 103 festgespannt ist. Die Platte hat vier parallele durchgehende Löcher für die Widerstände 21-24. Die Widerstände bestehen aus Metalldraht oder Körpern aus einem anderen geeigneten Widerstandsmaterial und sind fest eingegossen in den Löchern der Widerstandsplatte mit Hilfe einer elektrisch isolierenden Masse (z.B. 24c) mit einer genügend hohen Wärmeleitfähigkeit, z.B. einer keramischen Masse. Die Zuleitungen der Widerstände, z.B. 24a, 24b, ragen auf jeder Seite der Widerstandsplatte heraus, um den elektrischen Anschluß der Widerstände zu ermöglichen.

Die übrigen Kühlkörper 104-106, 107-109 usw. sind auf die gleiche Weise ausgeführt.

In gleicher Weise, wie bei den in den Figuren 1—3 gezeigten Ausführungsbeispiele der Erfindung sind die Spannungsteilerwiderstände 21—24 an dem zentralen Teil jedes Kühlkörpers angeordnet. Durch die auf den Stapel wirkende Spannkraft F wird die Widerstandsplatte an ihrem platz gehalten und ein guter thermischer Kontakt mit den Kühlplatten hergestellt. Auch in diesem Falle erhält man eine effektive Kühlung der Widerstände und eine minimale Wärmeabgabe an die Umgebung. Bei dem in Figur 4 gezeigten Ventilstapel ist der Austausch eines defekten Widerstandes außerordentlich einfach. Es ist nur die Spannkraft F wegzunehmen und die elektrischen Anschlüsse an die Widerstände der betreffenden Widerstandsplatte sind zu lösen, wonach die Widerstandsplatte herausgezogen und eine fehlerfreie Platte eingesetzt werden kann. Ferner ist die Anzahl der Flüssigkeitskupplungen und -dichtungen minimal, wodurch die Gefahr eines Kühlflüssigkeitslecks gering wird.

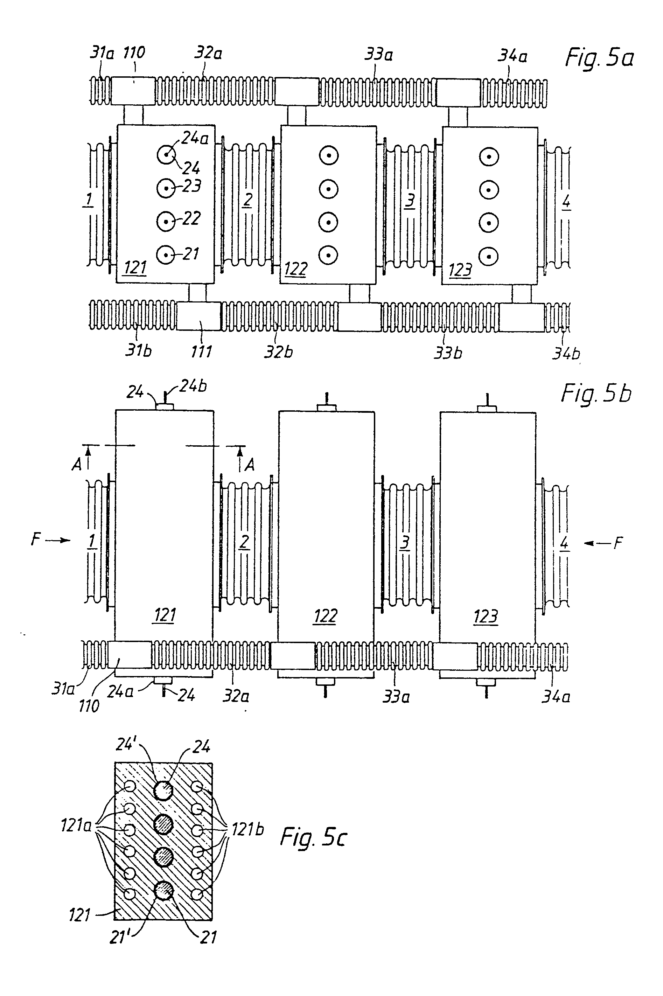

Figur 5 zeigt eine weitere Ausführungsform eines Halbleiterventils gemäß der Erfindung. Die Figuren 5a und 5b zeigen den Ventilstapel gesehen in zwei zueinander senkrechten Richtungen, und Figur 5c zeigt einen Schnitt längs der Linie A-A in Figur 5b. Zwischen den Halbleiterelementen (z.B. 1 und 2) liegen Kühlkörper 121-123, und der Ventilstapel wird mit der axialen Kraft F zusammengehalten, die von Spannvorrichtungen, beispielsweise der in Figur 1 gezeigten Art, erzeugt wird. Der Kühlkörper 121 hat zwei Gruppen paralleler Kühlflüssigkeitskanäle 121a und 121b an den auf die Halbleiterelemente gerichteten Flächen. Von dem Einlaufrohr 110 fließt die Kühlflüssigkeit über einen an dem einen Ende des Kühlkörpers vorgesehenen Sammelraum durch die Kanäle 121 zu einem an dem entgegengesetzten Ende vorhandenen Sammelraum und zurück durch die Kanäle 121b und einen Sammelraum zu dem Abflußrohr 111. Die Spannungsteilerwiderstände 21-24 sind in vier parallelen Löchern 21'-24' in dem Kühlkörper angeordnet. Die Widerstände sind vorzugsweise metallgekapselt. Um einen guten thermischen Kontakt zwischen den Widerstände und dem Kühlkörper zu bekommen, werden die Widerstände und die Löcher zweckmäßigerweise mit dem kleinstmöglichen Spiel, z.B. mit einem Schiebesitz, (das Spiel ist in Fig. 5c stark übertrieben dargestellt) ausgeführt. Um den Wärmeübergang zwischen den Widerstände und dem Kühlkörper weiter zu verbessern, können wärmeleitende Pasten oder Pulver verwendet werden u.B. Siliziumfett, Kohlepulver oder Metallpulver, wobei in diesem Falle eventuell ein etwas größerer Spiel zwischen den Widerstände und den Löchern vorgesehen wird.

Statt zylindrisch können die Löcher und Widerstände etwas konisch ausgeführt werden, wobei man automatisch einen guten mechanischen und damit thermischen Kontakt erhält, wenn die Widerstände in die Löcher eingeführt werden.

Alternativ können, um die Kontaktfläche zu vergrößern und den Wärmeübergang zu verbessern, die Widerstände und Löcher derart mit Gewinde versehen werden, daß die Widerstände in den Kühlkörper einschraubar sind.

Gemäß einer weiteren Alternative kann das Spiel zwischen Widerstand und Loch so groß gemacht werden, daß Platz für eine elastische vorzugsweise metallische Zwischenlage vorhanden ist, zum Beispiel für ein wellenförmiges, federndes Blech, das einerseits eine Druckkraft zwischen dem Widerstand und der Wand des Loches erzeugt und andererseits mit gutem Wärmeleitvermögen Wärme zwischen dem Widerstand und dem Kühlkörper transportiert.

Die übrigen Kühlkörper in dem Ventilstapel sind in gleicher Weise wie der oben beschriebene Kühlkörper 121 aufgebaut.

Auch bei dieser Ausführungsform gemäß der Erfindung sind die Widerstände an dem zentralen Teil jedes Kühlkörpers angeordnet, und es werden dieselben Vorteile wie bei den zuvor beschriebenen Ausführungsformen erzielt. Außerdem kann bei dem in Figur 5 gezeigten Stapel jeder Widerstand für sich ausgetauscht werden, und zwar ohne Wegnahme der auf den Stapel wirkende Spannkraft.

Die vorstehend beschriebenen Ausführungsformen der Erfindung sind nur Beispiele, und im Rahmen der Patentansprüche sind andere Ausführungsformen möglich.

**Patentansprüche**

1. Halbleiterventil für Hochspannung mit mehreren elektrisch in Reihe geschalteten Halbleiterelementen (1-6) und mehreren flüssigkeitsdurchflossenen Kühlkörpern, welche mit den Halbleiterelementen einen Stapel bilden, in welchem jedes Halbleiterelement zwischen zwei Kühlkörpern liegt, mit Druckvorrichtungen (14, 15, 16, 17, 18, 19), die eine in Längsrichtung des Stapels wirkende Druckkraft erzeugen, und mit je einem zu jedem Halbleiterelement parallelgeschalteten Spannungsteilerabschnitt, welcher mindestens einen Widerstand (21-24) enthält, dadurch gekennzeichnet, daß mindestens ein Widerstand (z.B. 21) des Spannungsteilerabschnittes gekapselt ausgeführt ist und eine im wesentlichen längliche zylindrische Form hat und daß dieser Widerstand so angeordnet ist, daß er zumindest mit seinem Hauptteil innerhalb eines Kühlkörpers (8) und mit seiner Längsachse im wesentlichen senkrecht zur Längsachse des Ventils liegt.

2. Halbleiterventil nach Anspruch 1, dadurch gekennzeichnet, daß mehrere Widerstände (21-24) in dem Kühlkörper nebeneinander in einer zur Längsachse des Ventils senkrechten Ebene und mit ihren Längsachsen parallel zueinander angeordnet sind.

3. Halbleiterventil nach einem der vorhergehenden Ansprüche, dadurch gekennzeichnet, daß die beiden Enden der Widerstände an je einer Seite des Kühlkörpers herausragen.

4. Halbleiterventil nach einem der vorhergehenden Ansprüche, dadurch gekennzeichnet, daß der Kühlkörper zwei parallele Anlageflächen für auf zwei Seiten des Kühlkörpers angeordnete Halbleiterelemente (1, 2) hat, daß der Kühlkörper einen zwischen den Anlageflächen liegenden zentralen Abschnitt hat, daß zwischen jeder Anlagefläche und dem zentralen Abschnitt eine Gruppe von Kühlflüssigkeitskanälen (841, 851; 121a, 121b) vorhanden ist und daß die Widerstände (21-24) in dem zentralen Abschnitt des Kühlkörpers untergebracht sind.

5. Halbleiterventil nach einem der vorhergehenden Ansprüche, dadurch gekennzeichnet, daß jeder der im Kühlkörper angeordneten Widerstände (z.B. 22) in einem von Kühlflüssigkeit durchflossenen Kanal (221) angeordnet ist.

6. Halbleiterventil nach Anspruch 5, dadurch gekennzeichnet, daß jeder Widerstand (z.B. 22) in einer separaten Bohrung (221) angeordnet ist, die einen größeren Querschnitt als der Widerstand hat und in axialer Richtung von Kühlflüssigkeit durchflossen wird.

7. Halbleiterventil nach Anspruch 4, dadurch gekennzeichnet, daß der Kühlkörper drei hintereinander in Längsrichtung des Stapels angeordnete Teile (101, 102, 103) enthält, daß in jedem der beiden äußeren, am dichtesten an den Halbleiterelementen liegenden Teilen (101, 103) die Kühlflüssigkeitskanäle (101a-f, 103a-f) angeordnet sind, daß das Mittelteil (102) von den beiden äußeren Teilen lösbar ist und daß in dem Mittelteil die Widerstände (21-24) angeordnet sind.

8. Halbleiterventil nach Anspruch 7, dadurch gekennzeichnet, daß das Mittelteil (102) mit je einer durchgehenden Bohrung für jeden der Widerstände versehen ist, daß in dem zentralen Teil dieser Bohrungen der aktive Teil der Widerstände angebracht ist und daß in dem Zwischenraum zwischen den aktiven Teilen der Widerstände und der Wand der Bohrungen ein elektrisch isolierendes Material (24c) vorhanden ist.

9. Halbleiterventil nach Anspruch 4, dadurch gekennzeichnet, daß der zentrale Abschnitt des Kühlkörpers mit je einer durchgehenden und von den Kühlflüssigkeitskanälen getrennten Ausbohrung 21'-24' für jeden Widerstand versehen ist, daß die Widerstände metallgekapselt sind und daß die Widerstände in ihrer Bohrung in einem guten thermischen Kontakt mit der Wand der Bohrung stehen.

**Revendications**

1. Valve à semiconducteurs pour haute tension comportant plusieurs éléments semiconducteurs (1-6) branchés électriquement en série et plusieurs corps de refroidissement traversés par un liquide, qui forment, avec les éléments semiconducteurs, une pile dans laquelle chaque élément semiconducteur est situé entre deux corps de refroidissement, et comportant des dispositifs de serrage (14, 15, 16, 17, 18, 19), qui produisent une force de pression agissant dans la direction longitudinale de la pile, et respectivement une section d'un diviseur de tension, qui est branchée en parallèle avec chaque élément semiconducteur et contient au moins une résistance (21-24), caractérisée par le fait qu'au moins une résistance (par exemple 21) de la section du diviseur de tension est encapsulée et possède une forme cylindrique nettement allongée et que cette résistance est disposée de telle sorte qu'au moins sa partie principale est située à l'intérieur d'un corps de refroidissement (8) et que son axe longitudinal est sensiblement perpendiculaire à l'axe longitudinal de la valve.

2. Valve à semiconducteurs suivant la revendication 1, caractérisée par le fait que plusieurs résistances (21-24) sont disposées côte-à-côte dans le corps de refroidissement, dans un plan perpendiculaire à l'axe longitudinal de la valve et avec leurs axes longitudinaux parallèles entre eux.

3. Valve à semiconducteurs suivant l'une des revendications précédentes, caractérisée par le fait que les deux extrémités des résistances font saillie sur des côtés respectifs du corps de refroidissement.

4. Valve à semiconducteurs suivant l'une des revendications précédentes, caractérisée par le fait que le corps de refroidissement comporte deux surfaces parallèles d'appui pour des éléments semiconducteurs (1, 2) disposés des deux côtés du corps de refroidissement, que le corps de refroidissement possède une section centrale située entre les surfaces d'appui et qu'un groupe de canaux (841, 851; 121a, 121b) véhiculant le liquide de refroidissement est présent entre chaque surface d'appui et la section centrale et que les résistances (21-24) sont logées dans la section centrale du corps de refroidissement.

5. Valve à semiconducteurs suivant l'une des revendications précédentes, caractérisée par le fait que chacune des résistances (par exemple 22) disposées dans le corps de refroidissement est située dans un conduit (221) parcouru par le liquide de refroidissement.

6. Valve à semiconducteurs suivant la revendication 5, caractérisée par le fait que chaque résistance (par exemple 22) est disposée dans un perçage séparé (221), qui possède une section transversale supérieure en tant que résistance et est parcouru dans la direction axiale par le liquide de refroidissement.

7. Valve à semiconducteurs suivant la revendication 4, caractérisée par le fait que le corps de refroidissement contient trois parties (101, 102, 103) disposées les unes derrière les autres dans la direction longitudinale de la pile, que les canaux (101a-f, 103a-f) véhiculant le liquide de refroidissement sont disposés dans chacune des deux parties extérieures (101, 103) les plus proches des éléments semiconducteurs, que la partie médiane (102) peut être détachée des deux autres parties et que les résistances (21-24) sont disposées dans la partie médiane.

8. Valve à semiconducteurs selon la revendication 7, caractérisée en ce que la partie médiane (102) est pourvue d'un passage traversant pour chacune des résistances, que la partie active des résistances est logée dans la partie centrale de ces perçages et qu'un matériau électriquement isolant (24c) est présent dans l'espace intercalaire situé entre les parties actives des résistances et la paroi des perçages.

9. Valve à semiconducteurs suivant la revendication 4, caractérisée par le fait que la section centrale du corps de refroidissement comporte, pour chaque résistance, un perçage traversant (21'-14'), séparé des canaux véhiculant le liquide de refroidissement, que les résistances sont encapsulées sous un capot métallique et que, dans leur perçage, les résistances établissent un bon contact thermique avec la paroi du perçage.

**Claims**

1. Semiconductor valve for high voltages with a plurality of series-connected semiconductor elements (1-6) and a plurality of cooling bodies traversed by liquid and forming with the semiconductor elements a stack with each semiconductor element being positioned between two cooling bodies, with compression means (14, 15, 16, 17, 18, 19) generating a compression force in the longitudinal direction of the stack, and with one voltage divider section each connected in parallel to each of the semiconductor elements, which each of the voltage divider sections comprising at least one resistor, characterized in that at least one resistor (for example 21) of the voltage divider section is of the enclosed type and has an essentially elongated cylindrical form, and that this resistor is arranged such that it is positioned, at least with its main portion, within a cooling body (8) and with its longitudinal axis substantially perpendicular to the longitudinal axis of the valve.

2. Semiconductor valve according to claim 1, characterized in that a plurality of resistors (21-24) are arranged side by side in the cooling body in a plain perpendicular to the longitudinal axis of the valve and with their longitudinal axes parallel to each other.

3. Semiconductor valve according to any of the preceding claims, characterized in that the two ends of the resistors protrude from one side each of a cooling body.

4. Semiconductor valve according to any of the preeceding claims, characterized in that the cooling body is provided with two parallel contact surfaces for semiconductor elements (1, 2) arranged on two sides of the cooling body, that the cooling body has a central portion between said contact surfaces, that between each contact surface and the central portion there is a set of channels (841, 851; 121a, 121b) for cooling liquid, and that the resistors (21-24) are accommodated in the central portion of the cooling body.

5. Semiconductor valve according to any of the preceding claims, characterized in that each of the resistors (for example 22) arranged in the cooling body is positioned in a channel (221) traversed by cooling liquid.

6. Semiconductor valve according to claim 5, characterized in that each resistor (for example 22) is arranged in a separate bore (221) which has a larger cross section than the resistor and is traversed by cooling liquid in the longitudinal direction.

7. Semiconductor valve according to claim 4, characterized in that the cooling body comprises three portions (101, 102, 103) arranged in series in the longitudinal direction of the stack, that the cooling liquid channels (101a-f, 103a-f) are arranged in each of the two outer portions positioned closest to the semiconductor elements, that the central portion (102) is detachable from the two outer portions, and that the resistors (21-24) are arranged in the central portion.

8. Semiconductor valve according to claim 7 characterized in that the central portion (102) is provided with one through-bore for each of the resistors, that in the central portions of these bores the active parts of the resistors are accommodated, and that an electrically insulating material (24c) is arranged in the space between the active parts of the resistors and the wall of the bores.

9. Semiconductor valve according to claim 4, characterized in that the central portion of the cooling body is provided with a through-going bore (21/24), separated from the cooling liquid channels, for each resistor, that the resistors are enclosed in metal, and that the resistors are arranged in good thermal contact with the wall of their respective bore.

Fig. 1a

EP 0 142 678 B1

EP 0 142 678 B1

2

26 24 1c 1a 1b 19 19b

1 2 3 4 5 6

7 8 9 10 11 12 13

19a 14 16 30 31a 25 24 32a 33a 34a 35a 36a 37 17 15

Fig. 1b

*Fig. 2a*

*Fig.2b*

*Fig.2c*

## Fig. 3a

## Fig. 3b

## Fig. 3c

## Fig. 3d

Fig.4a

Fig.4b

Fig.4c

*Fig. 5a*

*Fig. 5b*

*Fig. 5c*